# EUROPÄISCHE PATENTSCHRIFT

(11) **EP 3 291 322 B1**
(45) Veröffentlichungstag und Bekanntmachung des Hinweises auf die Patenterteilung: **14.11.2018**
(21) Anmeldenummer: 17187398.7
(22) Anmeldetag: 23.08.2017
(51) Int. Cl.: H01L 51/42, H01L 51/48

(54) **VERFAHREN UND VORRICHTUNG ZUR HERSTELLUNG EINES SUBSTRATS**
METHOD AND DEVICE FOR PRODUCING A SUBSTRATE
PROCÉDÉ ET DISPOSITIF DE FABRICATION D'UN SUBSTRAT

(30) Priorität: 29.08.2016 DE 102016216187
(43) Veröffentlichungstag der Anmeldung: 07.03.2018
(73) Patentinhaber: Bayerisches Zentrum für Angewandte Energieforschung e. V., 97074 Würzburg (DE)
(72) Erfinder: EGELHAAF, Hans-Joachim, 90403 Nürnberg (DE); BRABEC, Christoph J., 90403 Nürnberg (DE); HOGA, Felix, 97074 Würzburg (DE); KUBIS, Peter, 97074 Würzburg (DE)
(74) Vertreter: Dr. Gassner & Partner mbB

(56) Entgegenhaltungen:
- US-A1- 2006 024 855
- TOMI HASSINEN ET AL: "Roll-to-roll compatible organic thin film transistor manufacturing technique by printing, lamination, and laser ablation", THIN SOLID FILMS, ELSEVIER, AMSTERDAM, NL, Bd. 571, Nr. Part 1, 28. November 2014 (2014-11-28), Seiten 212-217, XP002759688, ISSN: 0040-6090, DOI: 10.1016/J.TSF.2014.10.086 [gefunden am 2014-10-30]
- PETER KUBIS ET AL: "High precision processing of flexible P3HT/PCBM modules with geometric fill factor over 95%", ORGANIC ELECTRONICS., Bd. 15, Nr. 10, 26. Juni 2014 (2014-06-26) , Seiten 2256-2263, XP055443107, NL ISSN: 1566-1199, DOI: 10.1016/j.orgel.2014.06.006

## Beschreibung

Die Erfindung betrifft ein Verfahren zur Herstellung eines Substrats mit einer darauf aufgebrachten strukturierten Elektrode.
IMI-Schichten (IMI = ITO-Metall-ITO) werden häufig als untere Elektroden für organische Solarmodule oder hybride Solarmodule eingesetzt. Derartige IMI-Schichten werden üblicherweise durch eine Bearbeitung mit einem Laserwerkzeug strukturiert, um bestimmte Oberflächenmuster zu erzeugen. Diese Oberflächenstrukturierung erfolgt z. B. durch Laserablation, wodurch leitfähige Grate, Zacken oder Spitzen entstehen, die sich senkrecht oder schräg von der Oberfläche des IMI-Substrats erstrecken und eine Höhe von mehreren Mikrometern aufweisen können. Dadurch ergibt sich das Problem, dass diese Grate unerwünschte elektronische Nebenschlüsse oder Kurzschlüsse erzeugen, wenn die aus IMI bestehenden leitfähigen Grate eine oder die obere Elektrode des Solarmoduls berühren. Da die Grate mechanisch mit der IMI-Schicht verbunden sind, können sie nicht einfach mittels Druckluft weggeblasen oder durch eine Flüssigkeit weggespült werden. Auch das Abwischen der IMI-Schicht ist keine geeignete Maßnahme zum Entfernen der als Spitzen oder Zacken ausgebildeten Grate, da dabei Kratzer entstehen können.

Bei herkömmlichen Verfahren erfolgt nach der Herstellung der Solarzelle üblicherweise ein "shunt burning", indem durch Zuführen einer Spannung die störenden Grate beseitigt werden. Dabei verbrennt in der Umgebung der Grate auch eine auf der Elektrode aufgetragene organische Schicht. Das führt zu schwarzen Flecken im sichtbaren Bereich der Solarmodule. Durch diese Defekte wird nachteiligerweise die Lebensdauer der Solarmodule reduziert.

Ein weiteres herkömmliches Verfahren zum Entfernen von Graten ist das Abwischen mit einem textilen Pad, das mit einem Lösungsmittel getränkt ist. Allerdings hängt das Ergebnis stark von der Sorgfalt derjenigen Person ab, die das Verfahren durchführt. Keines der beiden Verfahren ist daher für die Herstellung von organischen oder hybriden Solarmodulen in einem industriellen Maßstab geeignet.

Thin Solid Films, 2014, 571, 212-217 offenbart ein Herstellungsverfahren wobei Substrate mit Elektroden inspiziert werden und nur die Substrate verwendet werden die keine Grate enthalten.

US 2006/0024855 A1 offenbart ein Verfahren zur Herstellung einer Vorrichtung mit mindestens einer strukturierten Elektrode, wobei Grate auf der Elektrode mit einer isolierenden Schicht bedeckt werden.

Org. Electron., 2014, 15, 2256-2263 offenbart ein Verfahren zur Herstellung einer Vorrichtung, wobei Substrate mit strukturierten Elektroden gewaschen werden und die Grate somit mechanisch entfernt werden. Der Erfindung liegt daher die Aufgabe zu Grunde, ein Verfahren zum Entfernen eines sich infolge der Strukturierung von der Elektrode erstreckenden Grats anzugeben, das automatisiert und in einem industriellen Maßstab durchgeführt werden kann.
Zur Lösung dieser Aufgabe ist ein Verfahren mit den Verfahrensschritten gemäß Patentanspruch 1 vorgesehen.
Erfindungsgemäß umfasst das Verfahren die folgenden Schritte:
- Bereitstellen einer mit einer elektrisch isolierenden Schicht überdeckten Gegenelektrode,
- Bewegen der Gegenelektrode in Richtung der Elektrode, so dass der Grat die isolierende Schicht durchdringt und die Gegenelektrode berührt, und
- Anlegen einer Spannung an die Elektrode und die Gegenelektrode derart, dass der Grat durch den darüber fließenden Strom thermisch zerstört wird.
Die Erfindung beruht auf der Erkenntnis, dass das an sich bekannte "shunt burning" so modifiziert und kontrolliert angewendet werden kann, dass Grate einer Elektrode gezielt und kontrolliert durch einen elektrischen Stromfluss beseitigt werden können. Beim Anlegen einer elektrischen Spannung an die Elektrode und die elektrisch leitfähige Komponente der Gegenelektrode fließt ein Strom über die Grate.
Unter dem Begriff "Gegenelektrode" wird eine Einrichtung verstanden, welche mit den sich von der Elektrode erstreckenden Graten zumindest solange in Kontakt gebracht werden kann, bis die Grate thermisch zerstört sind. Danach wird die Gegenelektrode wieder entfernt. - Das Inkontaktbringen der Gegenelektrode mit den Graten erfolgt vor dem Aufbringen einer organischen Schicht auf die Elektrode. Infolgedessen kann die später aufgebrachte organische Schicht durch die thermische Zerstörung der Grate nicht beeinflusst werden. Die nach dem Stand der Technik durch das "shunt burning" hervorgerufenen schwarzen Flecken bzw. Defekte in der organischen Schicht werden vermieden. Die Lebensdauer einer derart hergestellten Solarzelle bzw. eines Solarmoduls kann damit erheblich verlängert werden.

Bei der "elektrisch isolierenden Schicht", welche die Gegenelektrode überdeckt, kann es sich insbesondere um eine weitere organische Schicht handeln. Die elektrisch isolierende Schicht ist in einer Dicke auf die Gegenelektrode aufgetragen, welche kleiner ist als eine maximale Höhe der Grate. Durch die elektrisch isolierende Schicht wird ein unerwünschtes Durchschlagen des Stroms in Bereichen vermieden, wo die Elektrode keine Grate aufweist. Ferner wird durch die elektrisch isolierende Schicht ein unmittelbarer Kontakt zwischen der Gegenelektrode und der Elektrode vermieden. Die Gegenelektrode kann auch beim Inkontaktbringen durch die elektrisch isolierende Schicht von der Elektrode beabstandet gehalten werden.

Wegen des thermischen Zerstörens der Grate wird die elektrisch isolierende Schicht im Laufe der Zeit beschädigt. Sie kann dann von der Gegenelektrode entfernt und ersetzt werden.

Vorzugsweise wird bei dem erfindungsgemäßen Verfahren eine ITO-Metall-ITO-Schicht (IMI-Schicht) als Elektrode des Substrats verwendet.

Im Rahmen der Erfindung wird es bevorzugt, dass der wenigstens eine Grat durch die angelegte Spannung erwärmt und geschmolzen und/oder verdampft wird. Der Grat oder die Grate wirken als elektrische Widerstände, die unter der Wirkung des fließenden Stroms bis zu ihrem Schmelzpunkt, ggf. auch bis zum Verdampfen, erwärmt werden. Wenn ein Grat in den flüssigen Zustand übergeht, verringert sich seine Ausdehnung senkrecht zur IMI-Schicht, d. h. seine Höhe. Ein Grat kann dabei beispielsweise zu einem Tropfen oder einer Kugel verformt werden, so dass er nicht oder nur noch wenig von der Oberfläche der IMI-Schicht absteht. In dem Fall, wenn ein Grat durch die Wirkung des elektrischen Stroms so stark erhitzt wird, dass er verdampft wird, kann er auch vollständig verschwinden.

Gemäß einer Weiterbildung der Erfindung kann es vorgesehen sein, dass die Geschwindigkeit der Erwärmung des Grats durch Festlegen der Höhe der angelegten Spannung eingestellt wird. Eine höhere Spannung bewirkt einen größeren Stromfluss und somit eine schnellere Erwärmung und ggf. ein schnelleres Schmelzen des Grats.

Es liegt auch im Rahmen des Verfahrens, dass die Erwärmung des Grats durch Festlegen der Zeitdauer der angelegten Spannung eingestellt wird. Durch Abschalten der Spannung zu einem bestimmten Zeitpunkt ist es möglich, den oder die Grate lediglich teilweise zu entfernen, so dass deren Höhe unterhalb eines festgelegten Grenzwerts liegt.

Eine besonders bevorzugte Variante der Erfindung sieht vor, dass der Abstand zwischen der Gegenelektrode und der Elektrode verringert wird. Dementsprechend wird dadurch der Abstand zwischen der elektrisch leitfähigen Komponente der Gegenelektrode und der strukturierten Elektrode, insbesondere der IMI-Schicht, reduziert. Das erfindungsgemäße Verfahren wird zunächst mit einem bestimmten größeren Abstand durchgeführt, so dass besonders hohe Grate entfernt werden. Anschließend kann der Abstand zwischen der der Gegenelektrode und der Elektrode verringert werden, so dass auch niedrigere Grate durch Erwärmen, Schmelzen und/oder Verdampfen beseitigt werden. Demnach wird der Abstand vorzugsweise schrittweise reduziert, bis die Höhe aller Grate unterhalb eines bestimmten Grenzwerts liegt. Das Verändern des Abstands kann mittels einer entsprechenden Vorrichtung automatisch erfolgen, so dass die Höhe der Grate einer Elektrode in mehreren Bearbeitungsschritten reduziert werden kann. - Zu diesem Zweck kann die Gegenelektrode durch ihr Gewicht oder mittels einer vorgegebenen Federvorspannung gegen die Elektrode gezwungen werden.

Bei dem erfindungsgemäßen Verfahren kann eine plattenförmige Gegenelektrode eingesetzt werden, die mit der elektrisch isolierenden Schicht versehen ist. Die Gegenelektrode und die zu bearbeitende Elektrode werden bei dem Verfahren etwa in paralleler Ausrichtung übereinander elektrisch angeordnet und gegeneinander bewegt, bis der oder die Grate die isolierende Schicht durchdringen und die Gegenelektrode berühren.

Gemäß einer alternativen, jedoch besonders bevorzugten Variante des erfindungsgemäßen Verfahrens kann eine zylinderförmige Gegenelektrode mit einer inneren elektrisch leitfähigen Komponente und einer äußeren elektrisch isolierenden Schicht verwendet werden. Anstelle einer zylinderförmigen Gegenelektrode kann selbstverständlich auch eine rohrförmige Gegenelektrode verwendet werden. Die zylinderförmige oder rohrförmige Gegenelektrode kann vollständig aus einem elektrisch leitfähigen Material, vorzugsweise aus einem Metall oder einer Metalllegierung, beispielsweise aus Stahl oder Aluminium, bestehen. Gemäß einer ersten Variante wird die zylinderförmige oder rohrförmige Gegenelektrode drehbar angeordnet, während die Elektrode linear bewegt wird. Bei dieser Ausgestaltung berührt die umlaufende Gegenelektrode die Elektrode, so dass ggf. vorhandene Grate der IMI-Schicht der Elektrode die innere elektrisch leitfähige Komponente der Gegenelektrode berühren und unter der Wirkung des fließenden elektrischen Stroms geschmolzen und beseitigt werden. Die Elektrode kann dazu auf einer bewegbaren Aufnahme angeordnet sein. Gemäß einer alternativen zweiten Variante kann die Elektrode ortsfest angeordnet sein, wobei sich die Gegenelektrode auf der Elektrode abwälzt. Die Gegenelektrode ist dabei nicht ortsfest, sondern rollt über die Elektrode. Beiden Varianten ist gemeinsam, dass die Elektrode und die Gegenelektrode relativ zueinander bewegt werden.

Daneben betrifft die Erfindung eine Vorrichtung zum Herstellen eines Substrats mit einer darauf aufgebrachten strukturierten Elektrode. Die erfindungsgemäße Vorrichtung umfasst eine Aufnahme zum Aufnehmen des Substrats,
eine mit einer elektrisch isolierenden Schicht überdeckte Gegenelektrode, wobei eine Dicke der elektrisch isolierenden Schicht so gewählt ist, dass bei Inkontaktbringen der Gegenelektrode mit der Elektrode wenigstens ein von der Elektrode sich erstreckender Grat die elektrisch isolierende Schicht durchdringt und die Gegenelektrode berührt, und eine Spannungsquelle zur Erzeugung einer elektrischen Spannung zwischen der Elektrode und der Gegenelektrode derart, dass der Grat durch den darüber fließenden Strom thermisch zerstört wird.

Die erfindungsgemäße Vorrichtung ist besonders gut für Elektroden geeignet, welche als IMI-Schicht ausgebildet sind.

Die Vorrichtung umfasst vorzugsweise ein Mittel zum Einstellen des Abstands zwischen der Gegenelektrode und der Elektrode oder ein Mittel zum Einstellen des Abstands zwischen der Gegenelektrode und der Aufnahme für die Elektrode. Das Mittel zum Einstellen des Abstands kann beispielsweise als Linearantrieb oder als Spindeltrieb oder als Piezoaktor ausgebildet sein. Das Mittel ermöglicht eine hochgenaue Einstellung des Abstands im Mikrometerbereich.

Gemäß einer bevorzugten Variante ist die Gegenelektrode plattenförmig ausgebildet. Gemäß einer alternativen Ausgestaltung der erfindungsgemäßen Vorrichtung ist die Gegenelektrode zylinderförmig oder ringförmig ausgebildet und drehbar gelagert.

Es liegt auch im Rahmen der Erfindung, dass der Aufnahme ein Antrieb, vorzugsweise ein Linearantrieb, zum Bewegen der Elektrode relativ zur Gegenelektrode zugeordnet ist. So kann z. B. die auf der Aufnahme angeordnete Elektrode an der zylinderförmigen oder ringförmigen Gegenelektrode vorbei bewegt werden, um die Grate zu entfernen.

Die Erfindung wird nachfolgend anhand von Ausführungsbeispielen unter Bezugnahme auf die Zeichnungen näher erläutert. Die Zeichnungen sind schematische Darstellungen und zeigen:
- Fig. 1: ein erstes Ausführungsbeispiel einer erfindungsgemäßen Vorrichtung in einer geschnittenen Ansicht, während die zu bearbeitende Elektrode und die Gegenelektrode voneinander beabstandet sind,
- Fig. 2: die in Fig. 1 gezeigte Vorrichtung, während die Elektrode und die Gegenelektrode miteinander in Kontakt sind,
- Fig. 3: die in Fig. 2 gezeigte Vorrichtung nach dem Entfernen der Grate der Elektrode und
- Fig. 4: ein zweites Ausführungsbeispiel einer erfindungsgemäßen Vorrichtung mit einer zylinderförmigen Gegenelektrode.

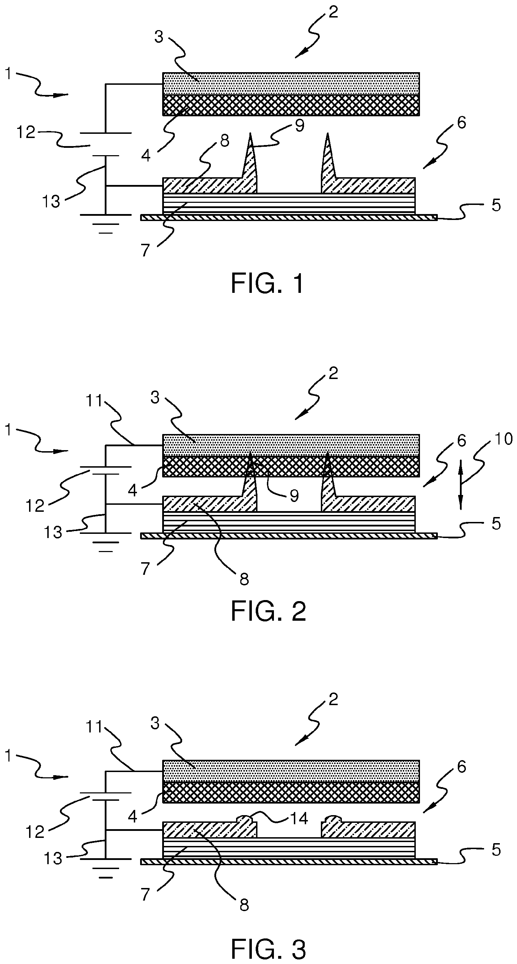

Die in Fig. 1 gezeigte Vorrichtung 1 umfasst eine Gegenelektrode 2 mit einer als Platte ausgebildeten elektrisch leitfähigen Komponente 3 und einer damit verbundenen elektrisch isolierenden Schicht 4. In dem dargestellten Ausführungsbeispiel besteht die elektrisch isolierende Schicht 4 aus einem Kunststoffmaterial, z. B. einem elektrisch isolierenden Lack oder dgl., und weist eine Dicke von 0,2 bis 1,0 µm, vorzugsweise 0,4 bis 0,6 µm, besonders bevorzugt etwa 0,5 µm auf. Daneben umfasst die Vorrichtung 1 eine schematisch dargestellte Aufnahme 5 für eine strukturierte Elektrode 6. In Fig. 1 ist die Elektrode 6 als eine auf einem Substrat 7 angeordnete ITO-Metall-ITO-Schicht (IMI-Schicht) 8 ausgebildet. Durch Laserbearbeitung der IMI-Schicht 8 weist diese mehrere Grate 9 auf, die sich zumindest näherungsweise von der Oberfläche der IMI-Schicht 8 in Richtung der Gegenelektrode 2 erstrecken. Um zu verhindern, dass durch diese Grate 9 unerwünschte Kurzschlüsse nach dem Aufbringen einer oberen Elektrode (nicht gezeigt) entstehen, werden die Grate 9 mittels der Vorrichtung 1 entfernt. Nach dem mittels des erfindungsgemäßen Verfahrens erfolgten Entfernen der Grate 9 können dann in üblicher Weise auf der Elektrode 6 weitere Schichten, insbesondere organische Schichten, sowie die obere Elektrode aufgebracht werden, so dass sich insgesamt eine organische Solarzelle oder ein organisches Solarmodul ergibt.

Fig. 2 zeigt die Vorrichtung 1, nachdem der Abstand zwischen der Elektrode 6 und der Gegenelektrode 2 verringert worden ist. Die Vorrichtung 1 weist dazu ein Mittel zum Einstellen des Abstands zwischen der Gegenelektrode 2 und der IMI-Schicht 8 auf, das z. B. als Linearantrieb (nicht gezeigt) ausgebildet ist. In Fig. 2 gibt ein Doppelpfeil 10 die Bewegungsrichtung der verstellbaren Gegenelektrode 2 gegenüber der ortsfesten Aufnahme 5 an. Selbstverständlich ist auch eine umgekehrte Variante denkbar, bei welcher die Gegenelektrode 2 ortsfest und die Aufnahme 5 mit der Elektrode 6 bewegbar ausgebildet ist.

In Fig. 2 erkennt man, dass der Abstand zwischen der Gegenelektrode 2 und der Aufnahme 5 soweit verringert wurde, dass die Grate 9 die elektrisch isolierende Schicht 4 durchdringen und die elektrisch leitfähige Komponente 3 der Gegenelektrode 2 berühren. Die als Stahlplatte ausgebildete elektrisch leitfähige Komponente 3 ist über eine elektrische Leitung 11 mit einer Spannungsquelle 12 verbunden. Diese ist über eine Leitung 13 mit Masse sowie mit der IMI-Schicht 8 verbunden. Durch das Anlegen der elektrischen Spannung wird ein elektrischer Stromkreis geschlossen, so dass Strom über die Grate 9 fließt. Da die aus der IMI-Schicht bestehenden elektrisch leitenden Grate 9 einen elektrischen Widerstand darstellen, werden die Grate 9 erwärmt. Durch die Wahl des Betrags der von der Spannungsquelle 12 bereitgestellten Spannung kann die Erwärmung so gesteuert werden, dass die Grate 9 kontrolliert schmelzen. Beim Schmelzen wird der elektrische Stromkreis unterbrochen.

Fig. 3 zeigt die Vorrichtung 1, nachdem die Grate 9 zu sphärischen Körpern 14 verformt worden sind. Da keine elektrische Verbindung zwischen den zu sphärischen Körpern 14 verformten Graten 9 und der plattenförmigen elektrisch leitfähigen Komponente 3 mehr besteht, fließt kein Strom mehr. Ausgehend von der in Fig. 3 gezeigten Position der Gegenelektrode 2 kann der Abstand zwischen der Gegenelektrode 2 und der Elektrode 6 weiter verringert werden, um ggf. vorhandene niedrigere Grate 9 in derselben Weise zu beseitigen. Das Verfahren wird beendet, wenn die Höhe aller verbleibenden Grate 9 unterhalb eines Grenzwerts liegt.

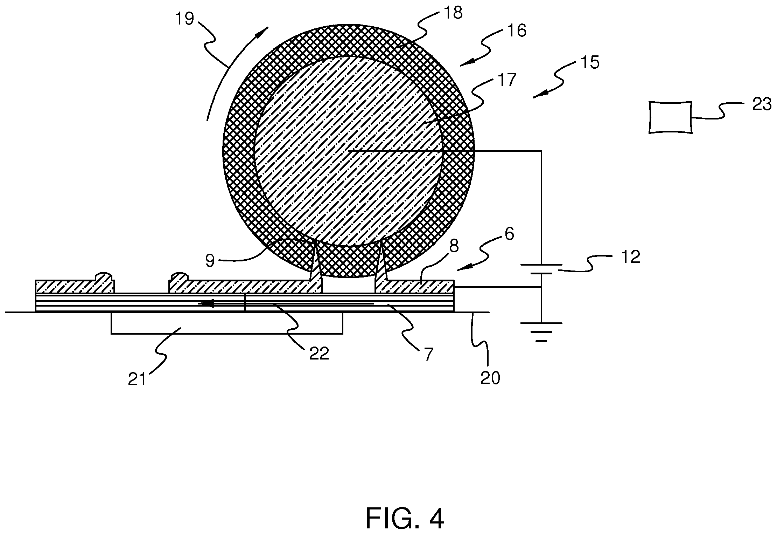

Fig. 4 zeigt ein weiteres Ausführungsbeispiel einer Vorrichtung 15 zum Entfernen wenigstens eines Grats 9 einer Elektrode 6. Die Vorrichtung 15 umfasst eine zylinderförmige Gegenelektrode 16 mit einer massiv ausgebildeten zylinderförmigen elektrisch leitenden Komponente 17, die außenseitig von einer elektrisch isolierenden Schicht 18, die aus einem Kunststoffmaterial mit einer Dicke von etwa 0,5 µm besteht, umhüllt ist. Die Gegenelektrode 16 ist drehbar gelagert. Die Drehrichtung wird durch einen Pfeil 19 angegeben.

Die Vorrichtung 15 umfasst ferner eine Aufnahme 20, auf welcher die Elektrode 6 angeordnet ist. In Übereinstimmung mit dem ersten Ausführungsbeispiel umfasst die Elektrode 6 das Substrat 7 und die IMI-Schicht 8. Um die Grate 9 der IMI-Schicht 8 zu beseitigen, wird der Abstand zwischen der Gegenelektrode 16 und der Elektrode 6 so eingestellt, dass die die elektrisch isolierende Schicht 18 durchdringenden Grate 9 die elektrisch leitfähige zylinderförmige Komponente 17 berühren. Der Aufnahme 20 ist ein schematisch dargestellter Linearantrieb 21 zugeordnet, der dazu ausgebildet ist, die auf der Aufnahme 20 angeordnete Elektrode 6 in Richtung des Pfeils 22 zu bewegen. Die elektrisch leitfähige Komponente 17 der Gegenelektrode 16 ist über eine elektrische Leitung mit einem Pol der Spanungsquelle 12 verbunden. Der andere Pol ist mit der IMI-Schicht 8 elektrisch verbunden. Beim Anlegen einer Spannung fließt ein elektrischer Strom über die Grate 9, die in Übereinstimmung mit dem ersten Ausführungsbeispiel dadurch erwärmt und geschmolzen werden, wodurch sie teilweise oder vollständig verschwinden oder z. B. zu einem sphärischen Körper verformt werden. Wenn der Linearantrieb 21 die Aufnahme 20 in Richtung des weiteren Pfeils 22 bewegt, wälzt sich die Gegenelektrode 16 auf der IMI-Schicht 8 ab. Die Drehrichtung wird durch den Pfeil 19 angegeben. Die Gegenelektrode 16 rollt somit über die Elektrode 6, wobei die unerwünschten Grate 9 beseitigt werden. Nachdem die Gegenelektrode 6 die gesamte Oberfläche der Elektrode 6 überstrichen hat, ist die Höhe der verbleibenden Grate 9 kleiner als ein festgelegter Grenzwert, der durch Einstellen des Abstands zwischen der Gegenelektrode 16 und der IMI-Schicht 8 festgelegt wird.

Eine Variante der Vorrichtung 15 sieht eine Steuerung 23 vor, die sowohl den Abstand zwischen der Gegenelektrode 16 und der Elektrode 6 als auch das Einschalten bzw. Ausschalten der Spannung und den Linearantrieb 21 steuert. Dementsprechend ist es möglich, die Elektrode 6 durch mehrere aufeinanderfolgende Schritte zu bearbeiten, um die Höhe der Grate 9 schrittweise zu reduzieren.

Eine sich parallel zur Drehachse der Gegenelektrode erstreckende Breite ist zweckmäßigerweise so gewählt, dass sie einer Breite der zu bearbeitenden Elektrode entspricht. Damit ist es möglich, die vorgeschlagene Vorrichtung in eine Fertigungslinie einzubauen, bei welcher nach der Herstellung der Elektrode durch Inkontaktbringen mit der Gegenelektrode die Grate thermisch zerstört und nachfolgend auf die so behandelte Elektrode weitere Schichten aufgetragen werden können. Damit können in einfacher und kostengünstiger Weise insbesondere organische Solarzellen oder Solarmodule in einer verbesserten Qualität hergestellt werden.

### Bezugszeichenliste

- 1: Vorrichtung
- 2: Gegenelektrode
- 3: Komponente
- 4: elektrisch isolierende Schicht
- 5: Aufnahme
- 6: Elektrode
- 7: Substrat
- 8: IMI-Schicht
- 9: Grat
- 10: Doppelpfeil
- 11: elektrische Leitung
- 12: Spannungsquelle
- 13: elektrische Leitung
- 14: sphärischer Körper
- 15: Vorrichtung
- 16: Gegenelektrode
- 17: Komponente
- 18: elektrisch isolierende Schicht
- 19: Pfeil
- 20: Aufnahme
- 21: Linearantrieb
- 22: Pfeil
- 23: Steuerung

## Patentansprüche

1. Verfahren zur Herstellung eines Substrats (7) mit einer darauf aufgebrachten strukturierten Elektrode (6), wobei zur Entfernung eines sich infolge der Strukturierung von der Elektrode (6) erstreckenden Grats (9) folgende Schritte durchgeführt werden:
- Bereitstellen einer mit einer elektrisch isolierenden Schicht (4, 18) überdeckten Gegenelektrode (2, 16),
- Bewegen der Gegenelektrode (2, 16) in Richtung der Elektrode (6), so dass der Grat (9) die isolierende Schicht (4, 18) durchdringt und die Gegenelektrode (2, 16) berührt, und
- Anlegen einer Spannung an die Elektrode (6) und die Gegenelektrode (2, 16) derart, dass der Grat (9) durch den darüber fließenden Strom thermisch zerstört wird.

2. Verfahren nach Anspruch 1, **dadurch gekennzeichnet, dass** eine ITO-Metall-ITO-Schicht (IMI-Schicht) als Elektrode (6) verwendet wird.

3. Verfahren nach Anspruch 1 oder 2, **dadurch gekennzeichnet, dass** der wenigstens eine Grat (9) durch die angelegte Spannung erwärmt und geschmolzen und/oder verdampft wird.

4. Verfahren nach Anspruch 3, **dadurch gekennzeichnet, dass** die Geschwindigkeit der Erwärmung des Grats (9) durch Festlegen der angelegten Spannung eingestellt wird.

5. Verfahren nach Anspruch 3 oder 4, **dadurch gekennzeichnet, dass** die Erwärmung des Grats (9) durch Festlegen der Zeitdauer der angelegten Spannung eingestellt wird.

6. Verfahren nach einem der vorangehenden Ansprüche, **dadurch gekennzeichnet, dass** der Abstand zwischen der Gegenelektrode (2, 16) und der Elektrode (6) vorzugsweise schrittweise verringert wird.

7. Verfahren nach einem der vorangehenden Ansprüche, **dadurch gekennzeichnet, dass** eine zylinderförmige oder ringförmige Gegenelektrode (2, 16) mit einer inneren elektrisch leitfähigen Komponente (3, 17) und einer äußeren elektrisch isolierenden Schicht (4, 18) verwendet wird, wobei entweder die Gegenelektrode (2, 16) drehbar angeordnet wird und die Elektrode (6) linear bewegt wird oder dass die Elektrode (6) ortsfest angeordnet wird und die Gegenelektrode (2, 16) auf der Elektrode (6) abwälzt.

8. Vorrichtung (1, 15) zum Herstellen eines Substrats (7) mit einer darauf aufgebrachten strukturierten Elektrode (6), umfassend
eine Aufnahme zum Aufnehmen des Substrats (7),
eine mit einer elektrisch isolierenden Schicht (4, 18) überdeckte Gegenelektrode (2, 16), wobei eine Dicke der elektrisch isolierenden Schicht (4, 18) so gewählt ist, dass bei Inkontaktbringen der Gegenelektrode (2, 16) mit der Elektrode (6) wenigstens ein von der Elektrode (6) sich erstreckender Grat (9) die elektrisch isolierende Schicht (4, 18) durchdringt und die Gegenelektrode (2, 16) berührt, und
eine Spannungsquelle zur Erzeugung einer elektrischen Spannung zwischen der Elektrode (6) und der Gegenelektrode (2, 16) derart, dass der Grat (9) durch den darüber fließenden Strom thermisch zerstört wird.

9. Vorrichtung (1, 15) nach Anspruch 8, umfassend ein Mittel zum Einstellen eines Abstands zwischen der Gegenelektrode (2, 16) und der Elektrode (6) oder ein Mittel zum Einstellen des Abstands zwischen der Gegenelektrode (2, 16) und der Aufnahme (5, 20) für die Elektrode (6).

10. Vorrichtung (1) nach Anspruch 8 oder 9, wobei die Gegenelektrode (2) plattenförmig ausgebildet ist.

11. Vorrichtung (15) nach Anspruch 8 oder 9, wobei die Gegenelektrode (16) zylinderförmig oder ringförmig ausgebildet und drehbar gelagert ist.

12. Vorrichtung (1, 15) nach Anspruch 11, wobei der Aufnahme (5, 20) ein Antrieb, vorzugsweise ein Linearantrieb (21), zum Bewegen der Elektrode (6) relativ zur Gegenelektrode (16) zugeordnet ist.

## Claims

1. A method for producing a substrate (7) having a structured electrode (6) applied thereon, wherein the following steps are performed for removing a burr (9) extending from the electrode (6) as a result of the structuring:
- providing a counter electrode (2, 16) covered with an electrically insulating layer (4, 18);
- moving the counter electrode (2, 16) towards the electrode (6), so that the burr (9) penetrates the insulating layer (4, 18) and contacts the counter electrode (2, 16); and
- applying a voltage to the electrode (6) and the counter electrode (2, 16), such that the burr (9) is thermally destroyed by the current flowing thereover.

2. The method according to claim 1, **characterized in that** an ITO metal ITO layer (IMI layer) is used as an electrode (6).

3. The method according to Claim 1 or 2, **characterized in that** the at least one burr (9) is heated and melted and/or evaporated by the applied voltage.

4. The method according to claim 3, **characterized in that** the rate of heating the burr (9) is adjusted by setting the applied voltage.

5. The method according to claim 3 or 4, **characterized in that** heating the burr (9) is adjusted by setting the duration of the applied voltage.

6. The method according to one of the preceding claims, **characterized in that** the distance between the counter electrode (2, 16) and the electrode (6) is preferably gradually reduced.

7. The method according to one of the preceding claims, **characterized in that** a cylindrical or annular counter electrode (2, 16) having an internal electrically conductive component (3, 17) and an external electrically insulating layer (4, 18) is used, wherein either the counter electrode (2, 16) is rotatably arranged and the electrode (6) is moved linearly or that the electrode (6) is fixedly arranged and the counter electrode (2, 16) rolls off on the electrode (6).

8. A device (1, 15) for producing a substrate (7) having a structured electrode (6) applied thereon, comprising
an accommodation for receiving the substrate (7),
a counter electrode (2, 16) covered with an electrically insulating layer (4, 18), wherein a thickness of the electrically insulating layer (4, 18) is selected, such that when contacting the counter electrode (2, 16) with the electrode (6), at least one burr (9) extending from the electrode (6) penetrates the electrically insulating layer (4, 18) and contacts the counter electrode (2, 16), and
a voltage supply for generating an electrical voltage between the electrode (6) and the counter electrode (2, 16) such that the burr (9) is thermally destroyed by the current flowing thereover.

9. The device (1, 15) according to claim 8, comprising means for adjusting a distance between the counter electrode (2, 16) and the electrode (6), or means for adjusting the distance between the counter electrode (2, 16) and the accommodation (5, 20) for the electrode (6).

10. The device (1) according to claim 8 or 9, the counter electrode (2) being plate-shaped.

11. The device (15) according to claim 8 or 9, wherein the counter electrode (16) 5 is of cylindrical or annular design and is rotatably mounted.

12. The device (1, 15) according to claim 11, wherein a drive, preferably a linear drive (21), for moving the electrode (6) in relation to the counter electrode (16) is associated with the accommodation (5, 20).

## Revendications

1. Procédé de fabrication d'un substrat (7) avec une électrode (6) structurée déposée sur celui-ci, en ce que les étapes suivantes sont effectuées pour l'élimination d'une bavure (9) s'étendant suite à la structuration de l'électrode (6):
- mise à disposition d'une contre-électrode (2, 16) recouverte d'une couche électriquement isolante (4, 18),
- déplacement de la contre-électrode (2, 16) en direction de l'électrode (6) de sorte que la bavure (9) pénètre la couche isolante (4, 18) et entre en contact avec la contre-électrode (2, 16), et
- application d'une tension à l'électrode (6) et à la contre-électrode (2, 16) de telle sorte que la bavure (9) est détruite thermiquement par le courant passant dessus.

2. Procédé selon la revendication 1, **caractérisé en ce qu'**une couche ITO-Métal-ITO (couche IMI) est utilisée comme électrode (6).

3. Procédé selon la revendication 1 ou 2, **caractérisé en ce qu'**au moins une bavure (9) est échauffée par la tension appliquée puis fondue et/ou évaporée.

4. Procédé selon la revendication 3, **caractérisé en ce que** la vitesse de réchauffement de la bavure (9) est réglée par détermination de la tension appliquée.

5. Procédé selon la revendication 3 ou 4, **caractérisé en ce que** réchauffement de la bavure (9) est réglé par détermination de la durée de la tension appliquée.

6. Procédé selon l'une des revendications précédentes, **caractérisé en ce que** la distance entre la contre-électrode (2, 16) et l'électrode (6) est réduite de préférence progressivement.

7. Procédé selon l'une des revendications précédentes, **caractérisé en ce qu'**une contre-électrode (2, 16) de forme cylindrique ou annulaire avec un composant intérieur électro conducteur (3, 17) et une couche extérieure électriquement isolante (4, 18) est utilisée, **en ce que** soit la contre-électrode (2, 16) est disposée à rotation et l'électrode (6) est déplacée linéairement ou **en ce que** l'électrode (6) est disposée de manière fixe et la contre-électrode (2, 16) roule sur l'électrode (6).

8. Dispositif (1, 15) permettant la fabrication d'un substrat (7) avec une électrode (6) structurée déposée sur celui-ci, comprenant
un logement destiné à recevoir le substrat (7),
une contre-électrode (2, 16) recouverte d'une couche électriquement isolante (4, 18), en ce qu'une épaisseur de la couche électriquement isolante (4, 18) est sélectionnée de façon à ce qu'à mise en contact de la contre-électrode (2, 16) avec l'électrode (6) au moins une bavure (9) s'étendant depuis l'électrode (6) pénètre la couche électriquement isolante (4, 18) et entre en contact avec la contre-électrode (2, 16), et
une source de tension pour la génération d'une tension électrique entre l'électrode (6) et la contre-électrode (2, 16) est telle que la bavure (9) est détruite thermiquement par le courant passant dessus.

9. Dispositif (1, 15) selon la revendication 8, comprenant un moyen de réglage d'une distance entre la contre-électrode (2, 16) et l'électrode (6) ou un moyen de réglage de la distance entre la contre-électrode (2, 16) et le logement (5, 20) de l'électrode (6).

10. Dispositif (1) selon la revendication 8 ou 9, en ce que la contre-électrode (2) est réalisée sous forme de plaque.

11. Dispositif (15) selon la revendication 8 ou 9, en ce que la contre-électrode (16) est réalisée de manière cylindrique ou annulaire et est montée à rotation.

12. Dispositif (1, 15) selon la revendication 11, en ce qu'un entraînement, de préférence un entraînement linéaire (21), est attribué au logement (5, 20) pour le déplacement de l'électrode (6) par rapport à la contre-électrode (16).
